(19) Europäisches Patentamt

European Patent Office

Office européen des brevets

(11) **EP 0 716 524 B1**

(12) **EUROPÄISCHE PATENTSCHRIFT**

(45) Veröffentlichungstag und Bekanntmachung des Hinweises auf die Patenterteilung:
**28.02.2001  Patentblatt 2001/09**

(51) Int Cl.⁷: **H04L 7/033**, H03D 13/00

(21) Anmeldenummer: **95118983.6**

(22) Anmeldetag: **01.12.1995**

(54) **Phasendetektorschaltung**

Phase detector circuit

Détecteur de phase

(84) Benannte Vertragsstaaten:
**DE FR GB IT**

(30) Priorität: **06.12.1994  DE 4443417**

(43) Veröffentlichungstag der Anmeldung:
**12.06.1996  Patentblatt 1996/24**

(73) Patentinhaber: **SIEMENS AKTIENGESELLSCHAFT
80333 München (DE)**

(72) Erfinder: **Müllner, Ernst, Dr.Ing.
D-80995 München (DE)**

(56) Entgegenhaltungen:
**EP-A- 0 054 322         GB-A- 2 242 085
US-A- 5 301 196**

• **HOGGE: "A self correcting clock recovery circuit ", JOURNAL OF LIGHTWAVE TECHNOLOGY, NZ, USA, Dezember 1995, Band LT-3, Nr. 6, Seiten 1312 - 1314**

**Beschreibung**

Die Erfindung betrifft einen Phasendetektor zur Ermittlung des Phasenunterschieds zwischen einem digitalisierten Datensignal und dem Taktsignal eines Empfangsgerätes.

Durch Vergleich des empfangenen Datensignals mit einem abgetasteten Datensignal wird als Regelkriterium ein Phasensignal gewonnen, das nach dem Vergleich mit einem Referenzsignal zur Frequenzeinstellung eines Taktgenerators dient oder dessen Phase nachstellt.

Ein bekannter Phasendetektor ist in IEEE, Journal of Lightwave Technologie, VOL. LT-3, No. 6,. Seite 1312 bis 1314 beschrieben. Dieser Phasendetektor besteht aus zwei von einem internen Takt gesteuerten D-Kippstufen und zwei EXCLUSIVE-OR-Gattern, wobei die Eingänge eines EXCLUSIVE-OR-Gatters jeweils mit dem Eingang und dem Ausgang einer Kippstufe verbunden sind. So werden ein Phasensignal und ein Referenzsignal erzeugt, die voneinander subtrahiert werden und - durch ein Filter geglättet - einen Oszillator steuern, der das Taktsignal erzeugt.

Für extrem hohe Frequenzen über 10 GHz werden aus Laufzeitgründen die Kippstufen jeweils aus zwei taktzustandsgesteuerten Speicherstufen aufgebaut. Von jeder dieser Kippstufen wird jeweils die zweite Speicherstufe mit einem zum Taktsignal der ersten Speicherstufe invertierten Taktsignal angesteuert bzw. intern so ausgebildet, daß sie auf den invertierten Zustand des Taktsignals reagiert.

Die maximal verarbeitbare Datenrate wird wesentlich durch die Laufzeit der Speicherstufen bestimmt.

Außerdem sind die Ausgänge der Kippstufen ungleich belastet, was zu einem Temperaturgang der Schaltung führen kann.

In den Fällen, in denen das anliegende Datensignal nicht seine volle Amplitude aufweist, ergeben sich durch den Verstärkungseffekt der Kippstufen ungleiche Pegel, die bei der Zusammenfassung von Signalen in den EXCLUSIVE-OR-Gattern wieder zu Ungenauigkeiten führen.

Aufgabe der Erfindung ist es, eine für extrem hohe Datenraten geeignete Phasendetektorschaltung anzugeben.

Diese Aufgabe wird durch eine Phasendetektorschaltung nach Patentanspruch 1 gelöst.

Vorteilhafte Weiterbildungen der Erfindung sind in den Unteransprüchen beschrieben.

Ein großer Vorteil ergibt sich durch die Verwendung von zwei parallelen durch Schieberegister realisierten Datenwegen und eines Taktsignales, dessen Frequenz der halben Datenrate entspricht. In die Datenwege wird abwechselnd jeweils ein Bit des ursprünglichen Datensignals übernommen und mit der halben ursprünglichen Datenrate an die Ausgänge der Schieberegister geschoben. Die parallel vorliegenden Datenbits können weiterhin parallel verarbeitet werden; ebenso kann über einen Multiplexer ein abgetastetes Signal mit der ursprünglichen Datenrate wieder hergestellt werden.

Ein besonderer Vorteil ist - neben einer Halbierung der Datenrate in den Phasendetektorzweigen - daß die erste Speicherstufe jedes dieser Datenwege bei einem 'aktiven' Taktsignal transparent geschaltet wird und in diesem Zustand als Laufzeitglied wirkt.

Vorteilhaft ist auch die Verwendung von Verstärkerstufen, die zwischen den Datenausgängen der Speicherstufen und den Eingängen der EXCLUSIVE-OR-Gatter eingeschaltet werden. Diese sorgen für gleiche und geringe Lasten an den Datenausgängen und erzeugen durch die Verstärkung der abgegebenen Datensignale steile Flanken, so daß ein exaktes Phasensignal und ein exaktes Referenzsignal gewonnen wird.

Die Belastung der einzelnen Speicherstufen der Phasendetektorschaltung kann durch das Anschalten von Eingängen von zusätzlichen Verstärkerelementen vollständig symmetrisch aufgebaut werden.
Auch kann ein zweites EXCLUSIVE-OR-Gatter zur Erzeugung einer zweiten Referenzspannung angeschaltet werden, die mit der bisherigen Referenzspannung zusammengefaßt wird. Hierdurch ergibt sich ein weniger schwankender resultierender Referenzwert. Die Erfindung wird anhand von Ausführungsbeispielen näher beschrieben.

Es zeigen:

Fig. 1    ein Prinzipschaltbild der Phasendetektorschaltung,

Fig. 2    eine Variante zur Erzeugung zweier Referenzsignale,

Fig. 3    ein Zeitdiagramm und

Fig. 4    ein Zeitdiagramm bei optimaler Abtastung.

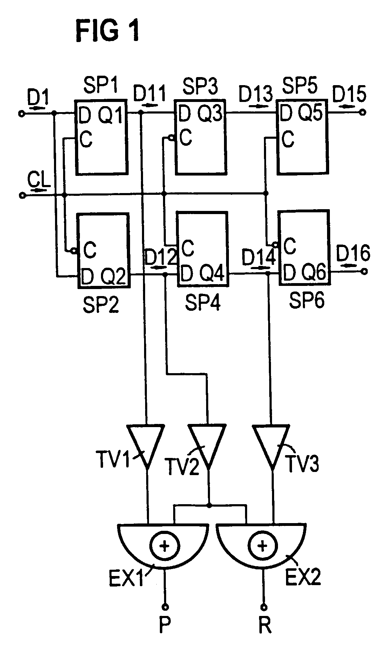

Die in Figur 1 dargestellte Phasendetektorschaltung enthält zwei Datenwege mit jeweils drei in Serie geschalteten Speicherstufen. Jeweils dem Dateneingang D der ersten Speicherstufe SP1 und SP2 jedes Datenweges wird ein Datensignal D1 zugeführt. Die Speicherstufen jedes Datenweges werden an ihren Takteingängen C abwechselnd mit einem nicht invertierten und einem invertierten Taktsignal CL bzw. $\overline{CL}$ angesteuert, dessen Taktfrequenz der halben Datenrate entspricht. Die erste, zweite und dritte Kippstufe SP2, SP4 und SP6 des zweiten Datenweges wird mit einem zum Taktsignal der ersten, zweiten oder dritten Speicherstufe SP1, SP3 und SP5 des ersten Datenweges invertierten Taktsignal angesteuert. Es können selbstverständlich auch Speicherstufen verwendet werden, die auf invertierte Taktsignale reagieren, wie dies in Figur 1 symbolisch dargestellt ist, oder als äquivalente Lösung zwei Taktsignale, deren wirksame Flanken um eine halbe Taktperiode phasenverschoben sind. Bei extrem hohen Datenraten werden mit antivalenten Taktsignalen (und Datensignalen) angesteuerte Speicherstufen verwendet; einer Invertierung des Taktsignals entspricht hier ein vertauschen der beiden antivalenten Taktsignale.

Die Datenausgänge Q1 und Q2 der ersten Speicherstufen SP1 und SP2 sind über Verstärkerschaltungen (Treiber) TV1 und TV2 auf Eingänge eines ersten EXCLUSIVE-OR-GATTERS (oder EXCLUSIVE-NOR-GATTERS) EX1 geführt. Dieses Gatter erzeugt das Phasensignal P. Ein Referenzsignal R wird von einem zweiten EXCLUSIVE-OR-Gatter (oder EXCLUSIVE-NOR-GATTERS) EX2 erzeugt, dessen erster Eingang ebenfalls an den Ausgang der zweiten Verstärkerstufe TV2 angeschaltet ist und dessen zweiter Eingang über eine dritte Verstärkerschaltung TV3 an den Datenausgang Q3 einer dritten Speicherstufe SP3, die der ersten Speicherstufe SP1 nachgeschaltet ist, angeschaltet ist. Das Referenzsignal kann auch durch Vergleich des abgetasteten Datensignals zu einem späteren Zeitpunkt gewonnen werden.

Die dritte Speicherstufe SP6 des zweiten Datenweges sorgt für die gleiche Belastung der Kippstufenausgänge Q2 und Q4 und entkoppelt die eigentliche Phasendetektorschaltung von den nachfolgenden Bauelementen. Die Speicherstufen SP3 und SP5 des ersten Datenweges dienen zum Ausgleich der Datenlaufzeiten in den beiden Datenwegen.

An den Datenausgängen Q5, Q6 der letzten Speichersufen SP5, SP6 der Datenwege werden die Ausgangs-Datensignale D15 und D16 abgegeben.

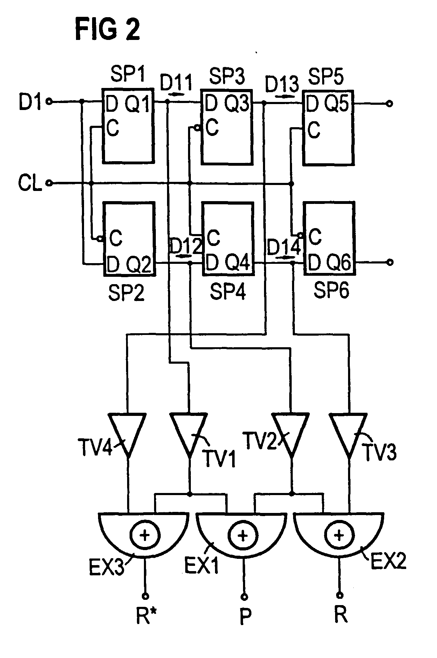

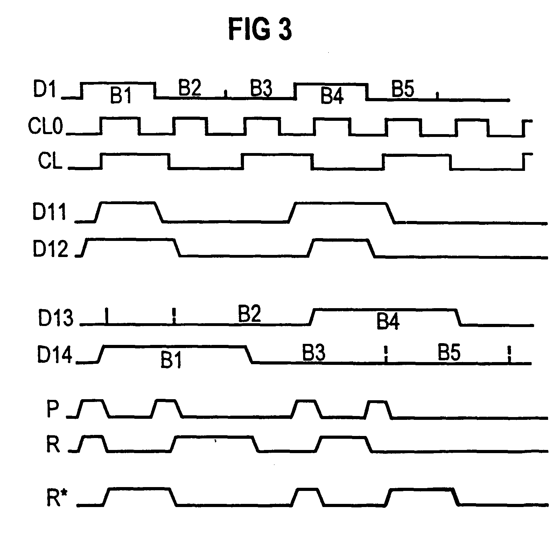

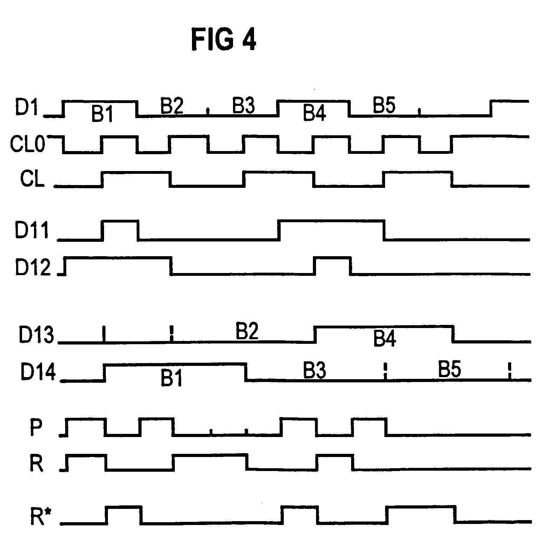

In Figur 2 ist eine besonders vorteilhafte Variante dargestellt, bei der zusätzlich ein zweites Referenzsignal R* erzeugt wird, das bereits in den Zeitdiagrammen Figur 3 und 4 eingezeichnet ist. Hierzu ist ein drittes EXCLUSIVE-OR-GATTER EX3 über eine weitere Verstärkerschaltung TV4 an die entsprechenden Datenausgänge Q1 und Q3 des ersten Datenweges angeschaltet.

Die Verwendung von zwei Referenzsignale R und R* sorgt für einen häufigeren Wechsel zwischen beiden logischen Zuständen eines resultierenden Referenzsignals, das mit dem Phasensignal verglichen werden. Als Regelkriterium erhält man R = 2P - (R + R*); dies kann durch Koeffizienten modifiziert werden.

In Zeitdiagramm Fig. 3 ist die Erzeugung des Phasensignals und der Referenzsignale R und R* dargestellt.

Die Phasendetektorschaltungen vergleichen das empfangene Datensignal mit einem mit dem Taktsignal CL des Empfangsgerätes abgetasteten Datensignal(d.h. sie messen die Phasendifferenz zwischen dem empfangenen Datensignal und dem Taktsignal). Das Ergebnis wird in der Regel mit einem Referenzsignal verglichen, das aus bereits abgetasteten Bits des Datensignals gebildet wird und - als Mittelwert - dem Phasensignal proportional ist.

Bei der vorliegenden Schaltung werden die Bits des Datensignals abwechselnd mit dem Zustand log. 1 des durch Teilung aus einem ursprünglichen Taktsignal CLO gewonnenen halbierten Taktsignals CL in dem oberen Datenweg an den Ausgang Q1 der Speicherstufe SP1 mit dem Zustand der log. 1 des Taktsignals und an den Ausgang Q2 der Speicherstufe SP2 des unteren Datenweges mit dem Zustand der log.0 des Taktsignals durchgeschaltet und mit dessen negativer bzw. positiver Flanke gespeichert.

Während eine Speicherstufe, z.B. die Speicherstufe SP1 bei einem die logische "1" darstellenden Taktsignal transparent geschaltet ist und somit das Datensignal D1 als Datensignal D11 an ihren Ausgang Q1 durchschaltet, bleibt der dieser Flanke des Taktsignals vorhergehende Zustand des Datensignals als Datensignal D12 in der Speicherstufe SP2 zunächst gespeichert. Durch das erste EXCLUSIVE-OR-GATTER EX1 wird jeweils ein durchgeschaltetes Datensignal D11 bzw. D12 mit einem abgetasteten Signal D12 bzw. D11 verglichen und so das Phasensignal P gebildet. Mit der nächsten Flanke des Taktsignals CL kehren sich die beschriebenen Zustände um. Jede erste Speicherstufe arbeitet somit abwechselnd als Verzögerungsglied und als Speicherstufe.

Die von den ersten Speicherstufen durchgeschalteten Datensignale D11 und D12 werden von den nachgeschalteten Speicherstufen SP3 und SP4 übernommen und als Datensignale D13 und D14 zwischengespeichert. Die einzelnen Bits des Datensignals sind mit Bezeichnungen B1, B2, ... versehen.

Das Referenzsignal R kann beispielsweise in jedem Datenweg (Schieberegister) durch Vergleich von abgetakteten Datenbits an verschiedenen Speicherstufenausgängen erfolgen. Figur 1 zeigt auch hierfür eine besonders vorteilhafte und aufwand sparende Lösung, bei der das Referenzsignal jeweils von den Ausgangssignalen D12 und D14 der ersten und zweiten Kippstufe eines Datenweges gebildet wird. Der Einfluß der unterschiedlichen Lage der Flanken des Datensignals hebt sich bei der Bildung des Referenzsignals auf.

Im Zeitdiagramm der Figur 3 eilt die Phase des Taktsignals CL und damit des abgetasteten Datensignals vor. Für das Phasensignal P ergibt sich dadurch im Vergleich zum Referenzsignal R ein zu kleiner Wert, der den Taktgenerator entsprechend nachregelt.

Wenn dagegen, wie in Figur 4 dargestellt, die Bits des Datensignals D1 exakt in der Mitte abgetastet werden, weisen das Phasensignal P und jedes Referenzsignal R und R* gleiche Mittelwerte auf.

Die Verstärkerstufen TV1 bis TV 4 dienen nicht allein dazu, die Belastungen an den Speicherstufenausgängen gering zu halten, sie dienen auch zur Verstärkung der Signale. Durch die ersten Speicherstufen können Amplitudenschwankungen des Eingangssignals noch nicht vollständig beseitigt werden. Durch den Vergleich von Signalen mit unterschiedlichen Amplituden treten aber Fehler auf, die sich als Fehler des Phasensignals und des Referenzsignals auswirken. Durch die Verstärkerstufen werden die Ausgangssignale verstärkt und begrenzt, so daß stets Signale mit gleichen Amplituden und versteilerten Flanken miteinander verglichen werden.

**Patentansprüche**

1. Phasendetektorschaltung mit einem ersten Datenweg mit mindestens einer taktzustandgesteuerten ersten Speicherstufe (SP1), der ein Datensignal (D1) und ein Taktsignal (CL) mit der halben Frequenz der Datenrate zugeführt werden, und mit einem zweiten Datenweg mit einer taktzustandgesteuerten zweiten Speicherstufe (SP2), der ebenfalls das Datensignal (D1) und ein zum Taktsignal der ersten Speicherstufe invertiertes Taktsignal ($\overline{CL}$) zugeführt werden, und mit mindestens einer an den Datenausgang (z.B. Q2) einer dieser Speicherstufen (SP1, SP2) angeschlossenen weiteren Speicherstufe (z.B. SP4), der wiederum ein zum Taktsignal der vorhergehenden Speicherstufe (z.B. SP2) invertiertes Taktsignal (CL) zugeführt wird, und

   mit einem ersten EXCLUSIVE-OR/NOR-Gatter (EX1), dessen erster Eingang an den Ausgang der ersten Speicherstufe (SP1) und dessen zweiter Eingang an den Ausgang der zweiten Speicherstufe (SP2) angeschaltet ist und mit mindestens einem zweiten EXCLUSIVE-OR/NOR-Gatter (EX2), dessen beide Eingänge an die Datenausgänge (z.B. Q2, Q4) von aufeinanderfolgenden Speicherstufen (z.B. SP2, SP4) eines der Datenwege angeschaltet sind.

2. Phasendetektorschaltung nach Anspruch 1,
   **dadurch gekennzeichnet,**
   daß in jedem Datenweg mindestens zwei in Reihe geschaltete Speicherstufen (SP1, SP3; SP2, SP4) vorgesehen sind, wobei jeweils der nachgeschalteten Speicherstufe (SP3, SP4) ein gegenüber dem Taktsignal (CL, $\overline{CL}$) der jeweils vorhergehenden Speicherstufe (SP1, SP2) invertiertes Taktsignal ($\overline{CL}$, CL) zugeführt wird und daß ein drittes EXCLUSIVE-OR/NOR-Gatter (EX3) vorgesehen ist, dessen beide Eingänge an Datenausgänge (z.B. Q1, Q3) von aufeinanderfolgenden Speicherstufen (z. B. SP1, SP3) des anderen Datenweges angeschaltet sind.

3. Phasendetektorschaltung nach Anspruch 1 oder 2,
   **dadurch gekennzeichnet,**
   daß das zweite EXCLUSIVE-OR/NOR-Gatter (EX2) an die Datenausgänge der ersten beiden aufeinanderfolgenden Speicherstufen (z.B. SP2 und SP4) eines Datenweges angeschaltet ist.

4. Phasendetektorschaltung nach Anspruch 3,
   **dadurch gekennzeichnet,**
   daß das dritte EXCLUSIVE-OR/NOR-Gatter (EX3) an die Datenausgänge der ersten beiden in Reihe geschalteten Speicherstufen (z.B. SP1 und SP3) des anderen Datenweges angeschaltet ist.

5. Phasendetektorschaltung nach einem der vorhergehenden Ansprüche,
   **dadurch gekennzeichnet,**
   daß zwischen den Datenausgängen der Speicherstufen (SP1, SP2, SP3, SP4) und den Eingängen der EXCLUSIVE-OR/NOR-Gatter (EX1 bis EX3) Verstärkerstufen (TV1 bis TV4) eingeschaltet sind.

6. Phasendetektorschaltung nach Anspruch 5,
   **dadurch gekennzeichnet,**
   daß an den Datenausgang einer Speicherstufe (SP1, SP2, SP3, SP4) jeweils nur eine Verstärkerstufe (TV1 bis TV4) angeschaltet ist und gegebenenfalls mehrere Eingänge der EXCLUSIVE-OR/NOR-Gatter (EX1 bis EX3) an einen Verstärkerausgang angeschaltet sind.

7. Phasendetektorschaltung nach einem der vorhergehenden Ansprüche,
   **dadurch gekennzeichnet,**
   daß in jeden Datenweg zur Entkopplung des Phasendetektors eine weitere Speicherstufe (SP5, SP6) in Reihe geschaltet ist.

8. Phasendetektorschaltung nach einem der vorhergehenden Ansprüche,
   **dadurch gekennzeichnet,**
   daß sämtliche Speicherstufen taktzustandsgesteuert sind.

9. Phasendetektorschaltung nach einem der vorhergehenden Ansprüche,
   **dadurch gekennzeichnet,**
   daß die zur Ansteuerung der Speicherstufen verwendeten Taktsignale (CL, $\overline{CL}$) antivalent sind.

**Claims**

1. Phase detector circuit having a first data path having at least one clock-state-controlled first memory stage (SP1), to which a data signal (D1) and a clock signal (CL) having half the frequency of the data rate are supplied, and having a second data path having a clock-state-controlled second memory stage (SP2), to which the data signal (D1) and a clock signal (CL) which is the inverse of the clock signal for the first memory stage are likewise supplied, and having at least one further memory stage (e.g. SP4), which is connected to the data output (e.g. Q2) of one of these memory stages (SP1, SP2) and to which, in turn, a clock signal (CL) which is the inverse of the clock signal for the preceding memory stage (e.g. SP2) is supplied, and

> having a first EXCLUSIVE-OR/NOR gate (EX1), whose first input is connected to the output of the first memory stage (SP1) and whose second input is connected to the output of the second memory stage (SP2), and
> having at least one second EXCLUSIVE-OR/ NOR gate (EX2), whose two inputs are connected to the data outputs (e.g. Q2, Q4) of successive memory stages (e.g. SP2, SP4) in one of the data paths.

2. Phase detector circuit according to Claim 1, characterized
in that each data path contains at least two series-connected memory stages (SP1, SP3; SP2, SP4), with a clock signal (CL, CL) which is the inverse of the clock signal (CL, $\overline{CL}$) for the respective preceding memory stage (SP1, SP2) being supplied to the memory stage (SP3, SP4) which is connected downstream in each case, and in that a third EXCLUSIVE-OR/NOR gate (EX3) is provided, whose two inputs are connected to data outputs (e.g. Q1, Q3) of successive memory stages (e.g. SP1, SP3) in the other data path.

3. Phase detector circuit according to Claim 1 or 2, characterized
in that the second EXCLUSIVE-OR/NOR gate (EX2) is connected to the data outputs of the first two successive memory stages (e.g. SP2 and SP4) in one data path.

4. Phase detector circuit according to Claim 3, characterized
in that the third EXCLUSIVE-OR/NOR gate (EX3) is connected to the data outputs of the first two series-connected memory stages (e.g. SP1 and SP3) in the other data path.

5. Phase detector circuit according to one of the preceding claims, characterized
in that amplifier stages (TV1 to TV4) are connected between the data outputs of the memory stages (SP1, SP2, SP3, SP4) and the inputs of the EXCLUSIVE-OR/NOR gates (EX1 to EX3).

6. Phase detector circuit according to Claim 5, characterized
in that only one amplifier stage (TV1 to TV4) is connected to the data output of a memory stage (SP1, SP2, SP3, SP4) in each case, and, if appropriate, a plurality of inputs of the EXCLUSIVE-OR/NOR gates (EX1 to EX3) are connected to one amplifier output.

7. Phase detector circuit according to one of the preceding claims, characterized
in that a further memory stage (SP5, SP6) is connected in series in each data path in order to decouple the phase detector.

8. Phase detector circuit according to one of the preceding claims, characterized
in that all the memory stages are clock-state-controlled.

9. Phase detector circuit according to one of the preceding claims, characterized
in that the clock signals (CL, $\overline{CL}$) used to drive the memory stages are non-equivalent.

## Revendications

1. Détecteur de phase avec un premier cheminement de données avec au moins un premier étage à mémoire (SP1), commandé par l'état du signal d'horloge, sur lequel sont amenés un signal de données (D1) et un signal d'horloge (CL) avec la demi-fréquence du débit de données, et avec un deuxième cheminement de données avec un deuxième étage à mémoire (SP2), sur lequel sont également amenés le signal de données (D1) et un signal d'horloge ($\overline{CL}$), inverti par rapport au signal d'horloge du premier étage à mémoire, et au moins un autre étage à mémoire (par ex. SP4), connecté à la sortie de données (par ex. Q2) de l'un de ces étages à mémoire (SP1, SP2) et auquel on amène, à son tour, un signal d'horloge (CL) inverti par rapport au signal d'horloge de l'étage à mémoire précédent (par ex. SP2), et

> avec, au moins, une première porte OU-EXCLUSIF/ NON-OU-EXCLUSIF (EX1), dont la première entrée est connectée à la sortie du premier étage à mémoire (SP1) et dont la deuxième entrée est connectée à la sortie du deuxième étage à mémoire (SP2), et
> avec, au moins, une deuxième porte OU-EXCLUSIF/ NON-OU-EXCLUSIF (EX2), dont les deux entrées sont connectées aux sorties de données (par ex. Q2, Q4) d'étages à mémoire qui se succèdent (par ex. SP2, SP4) de l'un des cheminements de données.

2. Détecteur de phase selon la revendication 1 **caractérisé par le fait**
que, sur chaque cheminement de données, sont prévus, au moins, deux étages à mémoire (SP1, SP3; SP2, SP4), montés en série, chacun des étages à mémoire montés en aval (SP3, SP4) recevant un signal d'horloge (CL, $\overline{CL}$) inverti par rapport au signal d'horloge (CL, $\overline{CL}$) de l'étage à mémoire respectif qui le précède (SP1, SP2), et par le fait qu'est prévue une troisième porte OU-EXCLUSIF/ NON-OU-EXCLUSIF (EX3) dont les deux entrées sont connectées sur des sorties de données (par ex. Q1, Q3) d'étages à mémoire qui se succèdent (par ex. SP1, SP3) de l'autre cheminement de données.

3. Détecteur de phase selon la revendication 1 ou 2 **caractérisé par le fait** que la deuxième porte OU-EXCLUSIF/ NON-OU-EXCLUSIF (EX2) est connectée aux sorties de données des deux premiers étages à mémoire qui se suivent (par ex. SP2 et SP4) d'un cheminement de données.

4. Détecteur de phase selon la revendication 3 **caractérisé par le fait** que la troisième porte OU-EXCLUSIF/ NON-OU-EXCLUSIF (EX3) est connectée aux sorties de données des deux premiers étages à mémoire montés en série (par ex. SP1 et SP3) de l'autre cheminement de données.

5. Détecteur de phase selon l'une des revendications précédentes **caractérisé par le fait** que des étages amplificateurs (TV1 à TV4) sont connectés entre les sorties de données des étages à mémoire (SP1, SP2, SP3, SP4) et les entrées des portes OU-EXCLUSIF/ NON-OU-EXCLUSIF (EX1 à EX3).

6. Détecteur de phase selon la revendication 5 caractérisé par le fait qu'un seul étage amplificateur (TV1 à TV4) est connecté à chaque sortie de données d'un étage à mémoire (SP1, SP2, SP3, SP4) et que, le cas échéant, plusieurs entrées des portes OU-EXCLUSIF/ NON-OU-EXCLUSIF (EX1 à EX3) sont connectées sur une sortie d'amplificateur.

7. Détecteur de phase selon l'une des revendications précédentes **caractérisé par le fait** qu'un autre étage à mémoire (SP5, SP6) est monté en série dans chaque cheminement de données pour le découplage du détecteur de phase.

8. Détecteur de phase selon l'une des revendications précédentes **caractérisé par le fait** que tous les étages à mémoire sont commandés par l'état du signal d'horloge.

9. Détecteur de phase selon l'une des revendications précédentes **caractérisé par le fait** que les signaux d'horloge (CL, $\overline{CL}$) utilisés pour l'excitation des étages à mémoire sont antivalents.

# FIG 1

# FIG 2

# FIG 3

# FIG 4